# EUROPÄISCHE PATENTSCHRIFT

(11) **EP 1 992 025 B1**
(45) Veröffentlichungstag und Bekanntmachung des Hinweises auf die Patenterteilung: **15.02.2012**
(21) Anmeldenummer: 07703544.2
(22) Anmeldetag: 23.02.2007
(51) Int. Cl.: H01M 2/10

(54) **ELEKTRISCHES GERÄT**
ELECTRICAL DEVICE
APPAREIL ELECTRIQUE

(30) Priorität: 07.03.2006 DE 102006010321
(43) Veröffentlichungstag der Anmeldung: 19.11.2008
(73) Patentinhaber: Braun GmbH, 61476 Kronberg (DE)
(72) Erfinder: DIETZEL, Daniel, 65779 Kelkheim (DE); HÖSER, Jürgen, 61267 Neu Anspach (DE); PIESKER, Thorsten, 61348 Bad Homburg (DE)
(86) Internationale Anmeldenummer: PCT/EP2007/001559
(87) Internationale Veröffentlichungsnummer: WO 2007/101558

(56) Entgegenhaltungen:
- CH-A- 456 699
- DE-A1- 2 361 625
- DE-A1- 2 525 500
- DE-A1- 3 935 366
- DE-A1- 19 733 361
- DE-A1- 19 944 192
- DE-U1- 8 504 602
- DE-U1- 20 009 946
- GB-A- 2 042 787
- JP-A- 1 106 658
- US-A- 3 609 262

## Beschreibung

Die Erfindung betrifft ein elektrisches Gerät mit einem Batteriefach mit den im Oberbegriff des unabhängigen Anspruchs 1 angegebenen Merkmalen.

Es sind bereits Geräte wie Batterierasierer usw. bekannt, die ein Batteriefach aufweisen, das durch ein auf das Batteriefach aufgeschobenes oder aufgerastetes Deckelteil nach außen verschlossen wird. Die Batterien oder Akkumulatoren werden in ein an dem Batteriefach ausgebildetes Aufnahmeteil eingesetzt und mit elektrischen Kontakten kontaktiert.

Aus der DE 197 33 361 A1 ist ein Verschlußdeckel mit bajonettmaßiger Ausführung bekannt, wobei der Verschlußdeckel einen Außenboden und einen drehbar in letzterem gelagerten Innenboden aufweist.

Die CH 456 699 A, GB 2 042 787 A, DE 85 04 602 U, DE 25 25 500 A zeigen ebenfalls Batteriedeckel mit bajonettartigem Verschluß.

Ein weiteres elektrisches Gerät ist aus der DE 199 44 192 A1 bekannt. Das Deckelteil wird bei diesem Gerät mit Rastmitteln auf ein Gehäuseteil aufgeklipst. Als weniger vorteilhaft wird jedoch bei dem bekannten Gerät angesehen, daß die Verbindung zwischen dem Gehäuseteil und dem Deckelteil durch die Wirkung einer unbeabsichtigten Kraft leicht gelöst werden kann.

Es ist daher Aufgabe der vorliegenden Erfindung, ein elektrisches Gerät der eingangs genannten Gattung dahingehend zu verbessern, daß ein unbeabsichtigtes Öffnen des Batteriefachs weitestgehend verhindert wird und der Deckel zur Entnahme oder zum Einsetzen von Batterien verliersicher von dem Gerät gelöst werden kann.

Diese Aufgabe wird erfindungsgemäß dadurch gelöst, daß der Deckel in der Längsrichtung des Batteriefachs begrenzt verschiebbar angeordnet ist.

Bei einer vorteilhaften Weiterbildung des Erfindungsgegenstandes sind die die Verriegelungsmittel durch ein mittels eines am Deckel anliegenden Drehverschlusses betätigbares, im Deckel drehbar gelagertes Verriegelungsteil sowie im Batteriefach ausgebildete Verriegelungsflächen gebildet, mit denen das Verriegelungsteil in Eingriff bringbar ist.

Bei einer anderen Ausführungsform der Erfindung sind mechanische Mittel vorgesehen, die beim Entriegeln oder Verriegeln des Deckelteiles einen deutlichen akustischen Effekt vermitteln. Die mechanischen Mittel sind vorzugsweise durch am Federelement ausgebildete, vorgespannte radiale Laschen sowie am Verriegelungsteil ausgebildete Rastnuten gebildet, in die die Laschen beim Verdrehen des Verriegelungsteiles um 90° einrasten.

Bei einer anderen Weiterbildung des Erfindungsgegenstandes sind die Rastnuten an einem Rastring ausgebildet, der mit dem Verriegelungselement lösbar verbunden ist. Die lösbare Verbindung des Rastrings mit dem Verriegelungselement ist vorzugsweise als eine Rastverbindung ausgebildet.

Eine weitere vorteilhafte Ausführungsvariante der Erfindung sieht vor, daß das Verriegelungselement mit axialen Schlitzen versehen ist, die radial nachgiebige Rastsegmente begrenzen, die mit einer Stirnfläche des Rastringes die Rastverbindung bilden.

Um den vorhin erwähnten akustischen Effekt zu verstärken weist der Rastring zwei radial gegenüber liegende Vorsprünge auf, die mit einem Spiel in Umfangsrichtung vom unteren Bereich der Schlitze aufgenommen werden.

Bei einer besonders preiswert herstellbaren Ausführung des Erfindungsgegenstandes sind das Batteriefach, das Verriegelungselement, das Deckelteil sowie der Drehverschluß aus Kunststoff gefertigt.

Bei einer weiteren Ausführung der Erfindung ist das elektrische Gerät ein elektrischer Rasierapparat. Der Drehverschluß dieses Geräts kann vorzugsweise eine Ausnehmung zur Aufnahme eines Reinigungsmittels aufweisen. gespannte radiale Laschen sowie am Verriegelungsteil ausgebildete Rastnuten gebildet, in die die Laschen beim Verdrehen des Verriegelungsteiles um 90° einrasten.

Bei einer anderen Weiterbildung des Erfindungsgegenstandes sind die Rastnuten an einem Rastring ausgebildet, der mit dem Verriegelungselement lösbar verbunden ist. Die lösbare Verbindung des Rastrings mit dem Verriegelungselement ist vorzugsweise als eine Rastverbindung ausgebildet.

Eine weitere vorteilhafte Ausführungsvariante der Erfindung sieht vor, daß das Verriegelungselement mit axialen Schlitzen versehen ist, die radial nachgiebige Rastsegmente begrenzen, die mit einer Stirnfläche des Rastringes die Rastverbindung bilden.

Um den vorhin erwähnten akustischen Effekt zu verstärken weist der Rastring zwei radial gegenüber liegende Vorsprünge auf, die mit einem Spiel in Umfangsrichtung vom unteren Bereich der Schlitze aufgenommen werden.

Bei einer besonders preiswert herstellbaren Ausführung des Erfindungsgegenstandes sind das Batteriefach, das Verriegelungselement, das Deckelteil sowie der Drehverschluß aus Kunststoff gefertigt.

Bei einer weiteren Ausführung der Erfindung ist das elektrische Gerät ein elektrischer Rasierapparat. Der Drehverschluß dieses Geräts kann vorzugsweise eine Ausnehmung zur Aufnahme eines Reinigungsmittels aufweisen.

Die Erfindung wird nachfolgend an einem Ausführungsbeispiel im Zusammenhang mit den beiliegenden Zeichnungen näher erläutert. In den Zeichnungen zeigen:
- Fig. 1a - 1d: einzelne Vorgänge beim Auswechseln der Batterien bei einem erfindungsgemäßen elektrischen Gerät;
- Fig. 2: eine Schnittdarstellung des elektrischen Geräts gemäß Fig. 1;
- Fig. 3: eine stark vergrößerte Schnittdarstellung des Verriegelungselementes beim erfindungsgemäßen elektrischen Gerät nach Fig. 2,
- Fig. 4: eine Schnittdarstellung des Verriegelungselementes nach Fig. 3 entlang der Schnittlinie A - A nach Fig. 3, und
- Fig. 5: eine Ansicht des Verriegelungselementes in Richtung des Pfeils "B" nach Fig. 3.

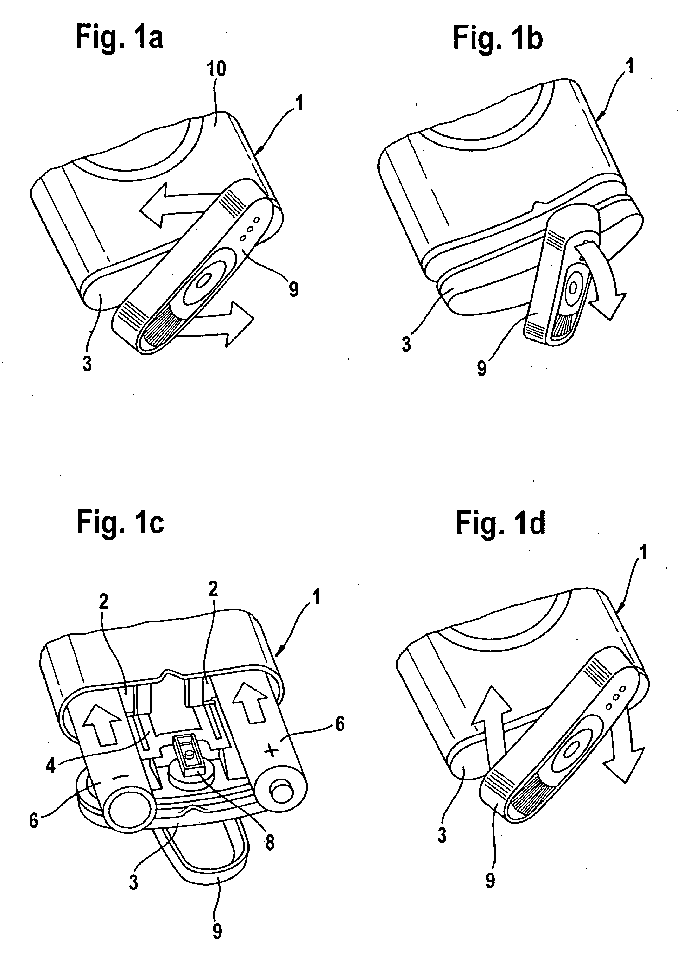

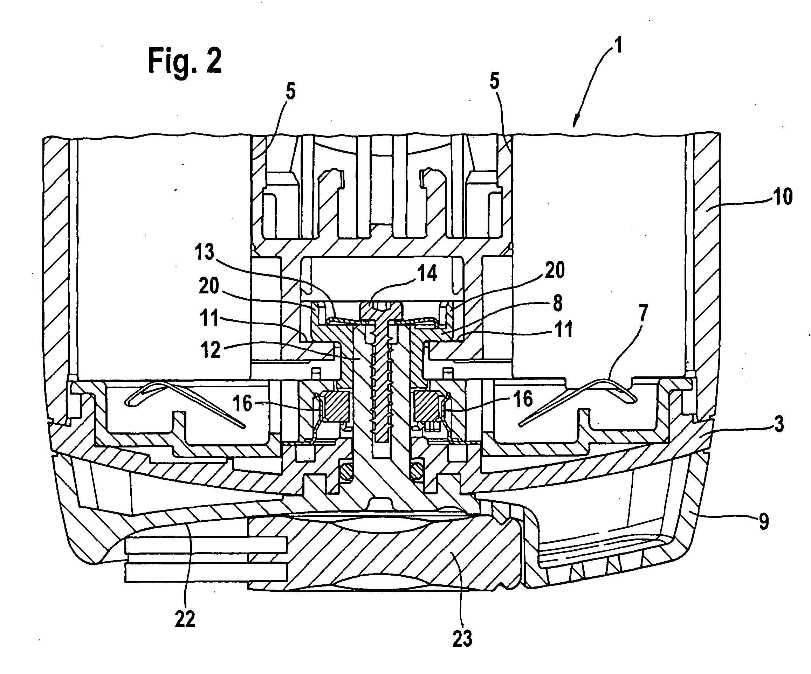

Die Fig. 1 und 2 der Zeichnung zeigen ein elektrisches Gerät 1, beispielsweise einen batteriebetriebenen Rasierapparat. Das Gerät 1 weist ein Gehäuse 10 auf, das in seinem unteren Teil ein Batteriefach 2 bildet. Das Batteriefach 2 ist durch einen Deckel 3 verschließbar, der mittels einer Führung 4 in der Längsrichtung des Batteriefachs 2 begrenzt verschiebbar gelagert ist. An der dem Deckel 3 zugewandten Seite des Batteriefachs 2 weist das Batteriefach 2 einen Aufnahmeabschnitt mit zwei Aufnahmeöffnungen 5 für jeweils eine im wesentlichen zylinderförmige Batterie 6 auf, deren Durchmesser in etwa dem Außendurchmesser der aufzunehmenden Batterien entspricht. Die elektrischen Kontakte des Gerätes, welche in der üblichen Art und Weise beim Einsetzen der Batterien an den Batteriekontakten zur Anlage gelangen, sind in der Zeichnung nicht dargestellt. Mit dem Bezugeszeichen 7 ist ein im Deckel 3 angeordnetes Federelement bezeichnet, durch welches die Batterien 6 in der Längsrichtung des Gehäuses 10 vorgespannt bzw. gegen die nicht gezeigten elektrischen Kontakte angedrückt werden.

Wie in der Zeichnung weiterhin zu erkennen ist, sind bei dem dargestellten Elektrorasierer Verriegelungsmittel 8, 9, 11, 20 vorgesehen, die zwischen dem Batteriefach 2 und dem Deckel 3 wirken und durch ein Verriegeln bzw. Entriegeln ein sicheres Halten des Deckels 3 in der geschlossenen Stellung (Fig. 1d, Fig. 2) bzw. sein Öffnen zum Zweck des Einsetzens der Batterien 6 (Fig. 1a -c) ermöglichen. Die Verriegelungsmittel bestehen aus einem im Deckel 3 drehbar gelagerten Verriegelungselement 8, einem Drehverschluß 9 zum Drehen des Verriegelungselementes 8, sowie Verriegelungsflächen 11, die innerhalb des Batteriefachs 2 ausgebildet sind und mit denen das Verriegelungselement 8 in der geschlossenen Stellung des Deckels 3 mittels ringsegmentförmiger radialer Vorsprünge 20 in Eingriff steht. Das Verriegelungselement 8 ist dabei mit einem axialen Fortsatz 12 des Drehverschlusses 9 unter Zwischenschaltung einer Haltefeder 13 durch eine Schraube 14 drehfest verbunden. Eine im Drehverschluß 9 ausgebildete Ausnehmung 22 dient der Aufnahme eines Reinigungselementes, beispielsweise eines Pinsels 23 zum Reinigen des nicht gezeigten Scherkopfes des Rasierapparats.

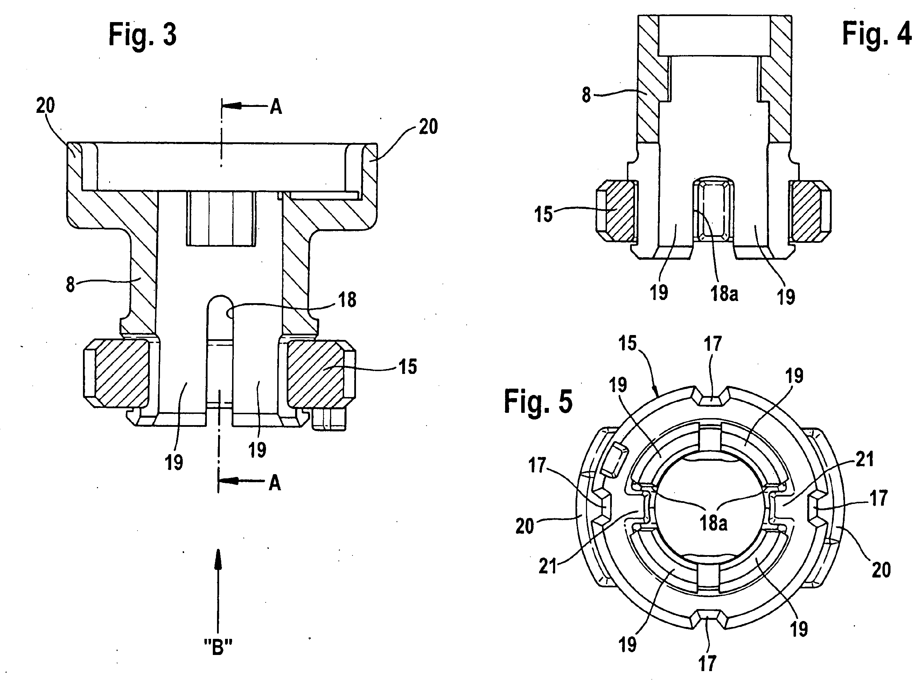

Außerdem ist der Zeichnung, insbesondere Fig. 2, zu entnehmen, daß mechanische Mittel 16, 17 vorgesehen sind, die beim Entriegeln oder Verriegeln des Deckelteiles 3 einen akustischen Effekt vermitteln. Die mechanischen Mittel 16, 17 werden durch am Federelement 7 ausgebildete, radial nach innen vorgespannte Laschen 16 sowie am Verriegelungselement 8 ausgebildete Rastnuten 17 (Fig. 5) gebildet. In die Rastnuten 17 rasten die Laschen 16 beim Verdrehen des Verriegelungselementes 8 um 90° sowohl im Uhrzeigersinn (Entriegeln) als auch gegen den Uhrzeigersinn (Verriegeln) ein.

Wie insbesondere den Darstellungen in Fig. 3 bis 5 entnehmbar ist, ist das Verriegelungselement 8 mittels einer Rastverbindung mit einem Rastring verbunden, der mit dem Bezugszeichen 15 versehen ist. Zu diesem Zweck weist das Verriegelungselement 8 axiale Schlitze 18, 18a auf, so daß radial nachgiebige Rastsegmente 19 gebildet werden, auf die der Rastring 15 aufgesteckt ist. Die vorhin erwähnten Rastnuten 17 sind an dem Rastring 15 ausgebildet. Außerdem ist in Fig. 5 zu erkennen, daß der Rastring 15 zwei radial gegenüber liegende, nach innen gerichtete Vorsprünge 21 aufweist, die mit einem Spiel in Umfangsrichtung von dem unteren Bereich der Schlitze 18a aufgenommen werden. Dadurch wird erreicht, daß der Rastring 15 und das Verriegelungselement 8 begrenzt gegeneinander verdreht werden können.

Wie bereits oben erwähnt wurde, zeigen die Fig. 1a bis 1d die einzelnen Vorgänge eines Batterieaustausches. Im ersten Vorgang (Fig. 1a) wird der Drehverschluß 9 gegen den Uhrzeigersinn um 90° gedreht. Durch die Drehbewegung werden die radialen Vorsprünge 20 außer Eingriff mit den Verriegelungsflächen 11 gebracht, wobei die radial vorgespannten Laschen 16 durch die Mantelfläche des Rastringes 15 radial nach außen auseinander gedrückt werden. Am Ende der Drehbewegung (s. Fig. 1b), an dem die radialen Vorsprünge 20 sich zwischen den Verriegelungsflächen 11 befinden, ist ein akustischer Effekt bzw. ein "Klick"-Geräusch vernehmbar, das dem Benutzer jeweils das Erreichen der entriegelten oder verriegelten Stellung der Verriegelungsmittel 8, 9, 11, 20 signalisiert, in der der Deckel 3 mit dem Drehverschluß 9 aus dem Gehäuse 10 heraus gezogen und nach unten in die in Fig. 1c gezeigte offene Position herunter geklappt werden kann, in der nicht gezeigte Batterien bzw. Akkumulatoren aus dem Batteriefach 2 entfernt und neue Batterien 6 ins Batteriefach 2 eingesetzt werden können. Das erwähnte "Klick"-Geräusch entsteht durch Einrasten der Laschen 16 in die Rastnuten 17 des Rastringes 15, wobei der akustische Effekt durch das im Zusammenhang mit Fig. 5 erwähnte Spiel zwischen den radialen Vorsprüngen 21 des Rastringes 15 und den Wänden der Schlitze 18a nochmals verstärkt wird. Nach dem Einsetzen der neuen Batterien bzw. Akkumulatoren 6 in das Gehäuse 10 wird das Batteriefach 2 mit dem Deckel 3 verschlossen und die Verriegelungsmittel werden durch Drehen des Drehverschlusses 9 um 90 ° im Uhrzeigersinn (s. Fig. 1d) verriegelt, wodurch der Deckel 3 in der geschlossenen Stellung arretiert wird. Das Erreichen der verriegelten Stellung der Verriegelungsmittel 8, 9, 11, 20 wird dem Benutzer des elektrischen Geräts 1 wieder durch ein lautes und deutlich hörbares "Klick"-Geräusch signalisiert.

## Patentansprüche

1. Elektrisches Gerät mit einem Batteriefach, einem Deckel zum Freigeben und Verschließen des Batteriefachs sowie einem im Batteriefach ausgebildeten Aufnahmeteil, in welches im wesentlichen zylinderförmige Batterien oder Akkumulatoren einsetzbar sind, zu deren elektrischer Kontaktierung ein Federelement vorgesehen ist, das bei geschlossenem Deckel gegen eine Stirnfläche der in das Aufnahmeteil eingesetzten Batterien oder Akkumulatoren angedrückt wird, wobei wirkungsmäßig zwischen dem Batteriefach (2) und dem Deckel (3) auf dem Prinzip eines Bajonett-Verschlusses wirkende Verriegelungsmittel (8,9,11) vorgesehen sind, **dadurch gekennzeichnet, daß** der Deckel (3) in der Längsrichtung des Batteriefachs (2) begrenzt verschiebbar angeordnet ist.

2. Elektrisches Gerät nach Anspruch 1, **dadurch gekennzeichnet, daß** die Verriegelungsmittel durch ein mittels eines am Deckel (3) anliegenden Drehverschlusses (9) betätigbares, im Deckel (3) drehbar gelagertes Verriegelungsteil (8) sowie im Batteriefach (2) ausgebildete Verriegelungsflächen (11) gebildet sind, mit denen das Verriegelungsteil (8) in Eingriff bringbar ist.

3. Elektrisches Gerät nach einem der Ansprüche 1 oder 2, **dadurch gekennzeichnet, daß** mechanische Mittel (16, 17) vorgesehen sind, die beim Entriegeln oder Verriegeln der Verriegelungsmittel (8, 9,11) einen akustischen Effekt vermitteln.

4. Elektrisches Gerät nach Anspruch 3, **dadurch gekennzeichnet, daß** die mechanischen Mittel (16, 17) durch am Federelement (7) ausgebildete, vorgespannte radiale Laschen (16) sowie am Verriegelungsteil (8) ausgebildete Rastnuten (17) gebildet sind, in die die Laschen (16) beim Verdrehen des Verriegelungsteiles (8) um 90° einrasten.

5. Elektrisches Gerät nach Anspruch 4, **dadurch gekennzeichnet, daß** die Rastnuten (17) an einem Rastring (15) ausgebildet sind, der mit dem Verriegelungselement (8) lösbar verbunden ist.

6. Elektrisches Gerät nach Anspruch 5, **dadurch gekennzeichnet, daß** der Rastring (15) mit dem Verriegelungselement (8) mittels einer Rastverbindung verbunden ist.

7. Elektrisches Gerät nach Anspruch 5 oder 6, **dadurch gekennzeichnet, daß** das Verriegelungselement (8) mit axialen Schlitzen (18, 18a) versehen ist, die radial nachgiebige Rastsegmente (19) begrenzen, die mit einer Stirnfläche des Rastringes (15) die Rastverbindung bilden.

8. Elektrisches Gerät nach Anspruch 7, **dadurch gekennzeichnet, daß** der Rastring (15) zwei radial gegenüber liegende Vorsprünge (21) aufweist, die mit einem Spiel in Umfangsrichtung vom unteren Bereich der Schlitze (18a) aufgenommen werden.

9. Elektrisches Gerät nach einem der vorher gehenden Ansprüche, **dadurch gekennzeichnet, daß** das Batteriefach (2), das Verriegelungselement (8), der Deckel (3) sowie der Drehverschluß (9) aus Kunststoff gefertigt sind.

10. Elektrisches Gerät nach einem der vorher gehenden Ansprüche, **dadurch gekennzeichnet, daß** das elektrische Gerät ein elektrischer Rasierapparat ist.

11. Elektrisches Gerät nach einem der vorher gehenden Ansprüche, **dadurch gekennzeichnet, daß** der Drehverschluß (9) eine Ausnehmung (22) zur Aufnahme eines Reinigungsmittels (23) aufweist.

## Claims

1. An electric device with a battery compartment, a cover for unsealing and sealing the battery compartment and an accommodating part formed in the battery compartment, into which accommodating part essentially cylindrical disposable or rechargeable batteries may be inserted, for which a spring element is provided for electrically contacting the batteries which spring element, when the cover is closed, is pressed against an end surface of the disposable or rechargeable batteries inserted into the accommodating part, wherein locking means (8, 9, 11) acting according to the principle of a bayonet closure are operatively provided between the battery compartment (2) and the cover (3), **characterized in that** the cover (3) is arranged for limited slidable displacement in the longitudinal direction of the battery compartment (2).

2. The electric device according to claim 1, **characterized in that** the locking means are formed by a rotatable mounted locking part (8) in the cover (3) as well as locking surfaces (11) formed in the battery compartment (2),which locking part (8) is operable by means of a turn-lock fastener (9) abutting the cover (3) , and with which the locking part (8) may be engaged.

3. The electric device according to one of the claims 1 or 2, **characterized in that** mechanical means (16, 17) are provided that produce an acoustic effect when the locking means (8, 9, 11) are unlocked or locked.

4. The electric device according to claim 3, **characterized in that** the mechanical means (16, 17) are formed by pre-tensioned radial tongues (16) formed on the spring element (7) and catch grooves (17) which are formed on the locking part (8), and which catch grooves (17) are engaged by the tongues (16) when the locking part (8) is rotated by 90°.

5. The electric device according to claim 4, **characterized in that** the catch grooves (17) are formed on a catch ring (15) that is detachably connected with the locking element (8).

6. The electric device according to claim 5, **characterized in that** the catch ring (15) is connected with the locking element (8) by means of a catch connection.

7. The electric device according to claim 5 or 6, **characterized in** the locking element (8) is provided with axial slits (18, 18a) that border radially flexible catch segments (19) which, together with an end surface of the catch ring (15), form the catch connection.

8. The electric device according to claim 7, **characterized in that** the catch ring (15) has two radially opposite projections (21) that are accommodated with play in the circumferential direction by the lower region of the slits (18a).

9. The electric device according to any one of the preceding claims, **characterized in that** the battery compartment (2), the locking element (8), the cover (3) and the turn-lock fastener (9) are produced from plastic.

10. The electric device according to any one of the preceding claims, **characterized in that** the electric device is an electric shaving apparatus.

11. The electric device according to any one of the preceding claims, **characterized in that** the turn-lock fastener (9) has a recess (22) to accommodate a cleaning element (23).

## Revendications

1. Appareil électrique comprenant un compartiment à piles, un couvercle permettant de libérer et de fermer le compartiment à piles, ainsi qu'une pièce de réception conçue dans le compartiment à piles et où il est possible d'insérer des piles ou des accumulateurs sensiblement cylindriques, pour la mise en contact desquels il est prévu un élément élastique qui, lorsque le couvercle est fermé, est pressé contre une face frontale des piles ou accumulateurs insérés dans la pièce de réception, des moyens de verrouillage (8, 9, 11) fonctionnant suivant le principe d'une fermeture à baïonnette étant prévus opérationnellement entre le compartiment à piles (2) et le couvercle (3), caractérisé en cequele couvercle (3) est monté en coulissement limité dans le sens longitudinal du compartiment à piles (2).

2. Appareil électrique selon la revendication 1, **caractérisé en ce que** les moyens de verrouillage sont formés par une pièce de verrouillage (8) activable à l'aide d'une fermeture rotative (9) appliquée contre le couvercle (3), montée en rotation dans le couvercle (3), ainsi que des surfaces de verrouillage (11) conçues dans le compartiment à piles (2) avec lesquelles la pièce de verrouillage (8) peut être mise en prise.

3. Appareil électrique selon l'une des revendications 1 ou 2, **caractérisé en ce que** des moyens mécaniques (16, 17) sont prévus, qui transmettent un effet acoustique lors du déverrouillage ou du verrouillage des moyens de verrouillage (8,9,11).

4. Appareil électrique selon la revendication 3, **caractérisé en ce que** les moyens mécaniques (16, 17) sont formés par des pattes radiales (16) précontraintes, conçues sur l'élément élastique (7), ainsi que des rainures d'encliquetage (17) conçues sur la pièce de verrouillage (8), dans lesquelles s'enclenchent les pattes (16) en cas de rotation de la pièce de verrouillage (8) de 90°.

5. Appareil électrique selon la revendication 4, **caractérisé en ce que** les rainures d'encliquetage (17) sont conçues sur un anneau d'encliquetage (15) qui est relié à l'élément de verrouillage (8) de façon amovible.

6. Appareil électrique selon la revendication 5, **caractérisé en ce que** l'anneau d'encliquetage (15) est relié à l'élément de verrouillage (8) à l'aide d'un assemblage par crantage.

7. Appareil électrique selon la revendication 5 ou 6, **caractérisé en ce que** l'élément de verrouillage (8) est doté de fentes axiales (18, 18a) qui délimitent des segments d'encliquetage radialement flexibles (19) qui, avec une surface frontale de l'anneau d'encliquetage (15), forment l'assemblage par crantage.

8. Appareil électrique selon la revendication 7, **caractérisé en ce que** l'anneau d'encliquetage (15) présente deux saillies (21) radialement opposées, qui sont reçues par la zone inférieure des fentes (18a) avec un jeu dans le sens périphérique.

9. Appareil électrique selon l'une des revendications précédentes, **caractérisé en ce que** le compartiment à piles (2), l'élément de verrouillage (8), le couvercle (3) ainsi que la fermeture rotative (9) sont réalisés en plastique.

10. Appareil électrique selon l'une des revendications précédentes, **caractérisé en ce que** l'appareil électrique est un rasoir électrique.

11. Appareil électrique selon l'une des revendications précédentes, **caractérisé en ce que** la fermeture rotative (9) présente un évidement (22) permettant de loger un moyen de nettoyage (23).
